# EUROPEAN PATENT APPLICATION

(11) **EP 0 917 416 A1**
(43) Date of publication of application: **19.05.1999**
(21) Application number: 97309257.0
(22) Date of filing: 18.11.1997
(51) Int. Cl.: H05K 7/14

(54) **Latch assembly**

(71) Applicant: DZUS FASTENER EUROPE LIMITED, Farnham, Surrey GU9 9PL (GB)
(72) Inventor: Lambert, Anthony, Guildford, Surrey, GU1 1YH (GB)
(74) Representative: Haley, Stephen

(57) **Abstract**

A latch assembly for latching two components comprises a retaining member for retaining, in use, the assembly on the first component. A first latching member engages, in use, with a second component. The latching member is pivotally attached to the retaining member such that it can pivot between a first position, in which it is not engaged with the second component and a second position in which it is engaged with the second component. A second latching member is rotatably attached to the retaining member and arranged such that it rotates and pivots the first latching member from its disengaged position to its engaged position.

## Description

There are many applications in which it is required to latch two components into engagement with one another in which it is difficult for a user carrying out the latching to exert sufficient force to ensure sufficient engagement of the two components for the required purpose.

A good example of such a situation is the latching of an electrical circuit board to a housing, in which it is required that, when the board and housing are in engagement, the engagement be such that good electrical contact is made between the board and the housing. Given that, in many situations, such components are in a confined region with restricted access, it is difficult for a user to ensure good engagement unless force is applied to sections of the board or housing that are not designed to withstand such force.

Furthermore, once such components are in engagement, it is often very difficult to remove them from engagement with one another without, again, requiring force to be applied to regions that are not designed to receive such force. The present invention seeks to overcome the above and other problems.

According to the present invention there is provided a latch assembly for latching two components comprising:
a retaining member for retaining, in use, the assembly on the first component;
a first latching member for engaging, in use, with a second component, the latching member being pivotally attached to the retaining member such that it can pivot between a first position, in which it is not engaged with the second component and a second position in which it is engaged with the second component; and
a second latching member rotatably attached to the retaining member and arranged such that, in use, it rotates to pivot the first latching member from its disengaged position to its engaged position.

The second latching member may be a wheel having teeth, the teeth engaging with the first latching member.

Alternatively, the second latching member may be cylindrical and have a screw thread on its exterior surface, the screw thread engaging with the first latching member to pivot it between its disengaged and engaged position.

Regardless of the type of second latching member, the second latching member may also be arranged to pivot the first latching member from its engaged position to its disengaged position.

The second and first latching members may be arranged so that the force applied by the first latching member as it engages with the second component is greater than the force applied by a user.

The latching assembly may be arranged to be retained, in use, on an electrical circuit board and engaged, in use, with a housing, or vice versa.

Because engagement/disengagement force for the latch is generated by rotation of the second latching member, it is generated by a user without undue effort, and without the need to exert force on the components to be latched.

One example of the present invention will now be described with reference to the accompanying drawings, in which:
Figure 1 is an isometric view of a first example of the present invention;
Figure 2 is a cross-sectional view of the example of Figure 1;
Figure 3 is a side view of a second example of the present invention in an un-latched state; and

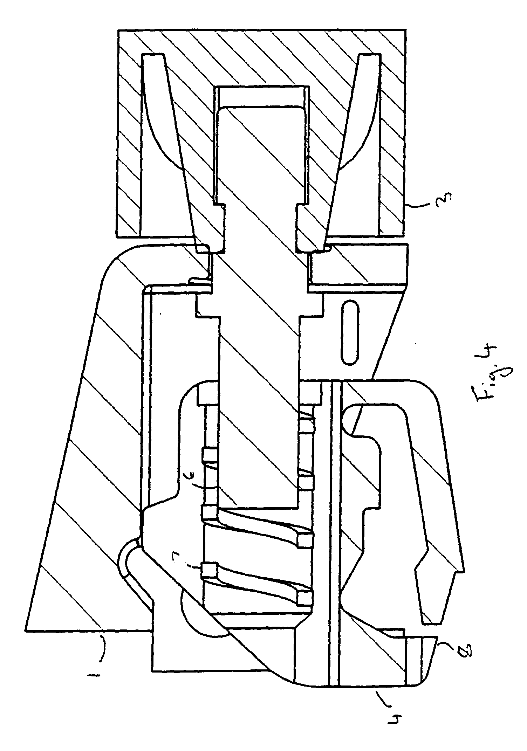

Figure 4 is a cross-sectional view of the example of Figure 3 in a latched state.

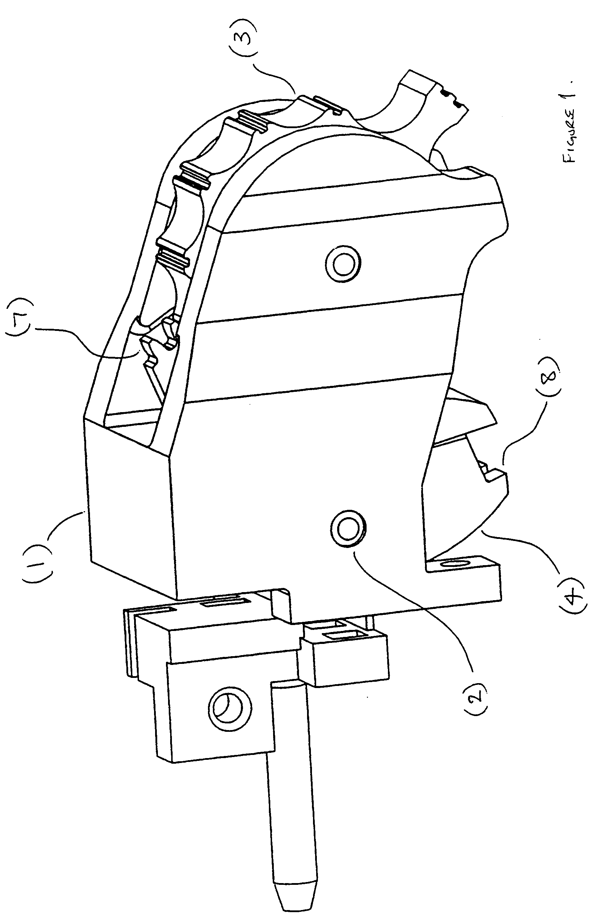

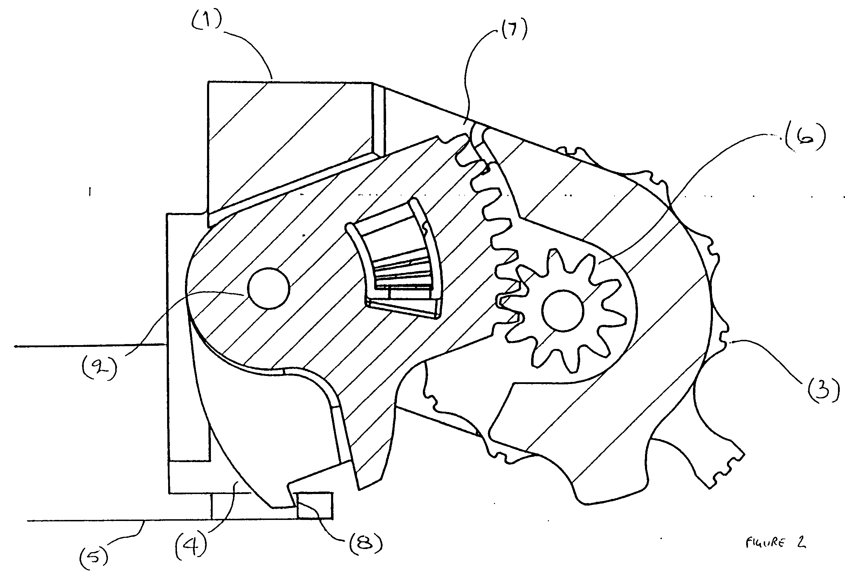

Referring to Figures 1 and 2, a latch assembly 1 is arranged to be retained, in use, on an electrical circuit board (not shown). Pivotally attached to the retaining member 1 of the latch assembly 1 is a first latching member 4. This is attached by a pivot pin 2.

Rotatably attached to the retaining member 1 is a second latching member 3 which has a series of teeth 6 which engage with teeth 7 on the first latching member 4.

In use, the retaining member 1 is brought into engagement with a second component (in this case a housing) 5 and the second latching member 3 rotated. Rotation of the second latching member 3 causes the first latching member 4 to pivot and teeth 8 on the first member 4 can engage with apertures in the housing 5, drawing the board, retaining member and housing into strong engagement with one another. Given the disparity in the ratio of teeth 6, 7 on the two latching members 3, 4 and the external diameter of the second latching member 3 the engaging force applied by the teeth 8 on the first latching member 4 is significantly higher than that applied by the user, ensuring good engagement with minimal user force.

Rotation of the second latching member 3 in its opposite direction draws the first latching member out of engagement with the housing 5, pushing the board (not shown) out of engagement also and ensuring removal of the board.

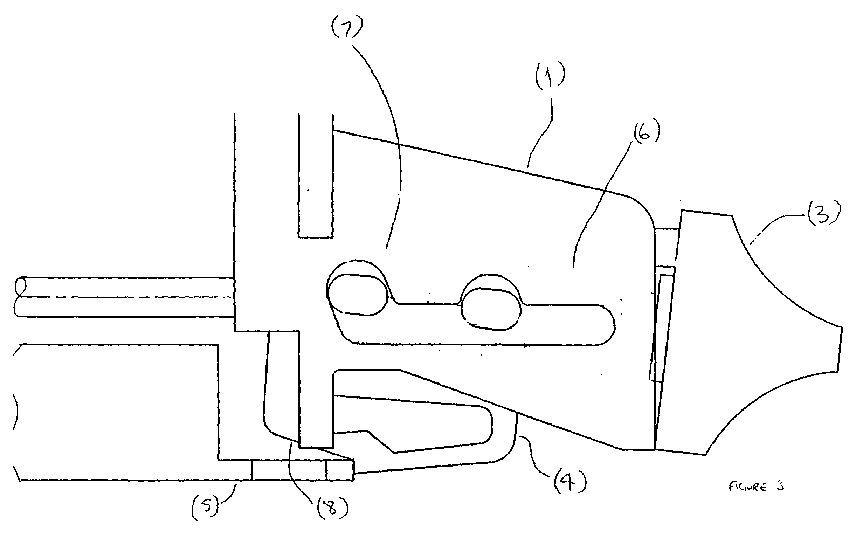

Figure 3 shows a second example of the invention in which components corresponding to those in the first example are numbered identically.

In this example, the second latching member 3 is in the form of a screw thread, which can be rotated so that its teeth 6 engage with teeth 7 on the first latching member 4, to pivot it in slots 9 from an un-latched to a latched state or vice versa, depending upon the direction of rotation of the second latching member 3. As with the first example, teeth 8, on the first member 4, engage in use with apertures in the housing 5. Further rotation of the second latching member 3, draws the first and second components into strong engagement with one another, by rotational movement being translated into linear movement via teeth 6 and 7. Rotation of the second latching member 3 in its opposite direction disengages the first and second components, and further rotation of second latching member 3, draws the first latching member 4 out of engagement with housing 5.

## Claims

1. A latch assembly for latching two components comprising:
a retaining member for retaining, in use, the assembly on the first component;
a first latching member for engaging, in use, with a second component, the latching member being pivotally attached to the retaining member such that it can pivot between a first position, in which it is not engaged with the second component and a second position in which it is engaged with the second component; and
a second latching member rotatably attached to the retaining member and arranged such that, in use, it rotates to pivot the first latching member from its disengaged position to its engaged position.

2. An assembly according to claim 1, wherein the second latching member is a wheel having teeth, the teeth engaging with the first latching member.

3. An assembly according to claim 1, wherein the second latching member is cylindrical and has a screw thread on its exterior surface, the screw thread engaging, in use, with the first latching member to pivot it between its disengaged and engaged position.

4. An assembly according to any of the preceding claims, wherein the second latching member is also arranged to pivot the first latching member from its engaged position to its disengaged position.

5. An assembly according to any of the preceding claims, wherein the second and first latching members are arranged so that the force applied by the first latching member when engaged with the second component is greater than the force applied by a user.

6. An assembly according to any of the preceding claims, arranged to be retained, in use, on an electrical circuit board and engaged, in use, with a housing.

7. An assembly according to any of claims 1 to 5, arranged to be engaged, in use, with an electrical circuit board and retained, in use, on a housing.
